Europäisches Patentamt

European Patent Office

Office européen des brevets

(11) Numéro de publication: **0 270 422 B1**

## (12) FASCICULE DE BREVET EUROPEEN

(45) Date de publication de fascicule du brevet:
**15.01.92**

(51) Int. Cl.⁵: **G01R 27/28**, G01R 31/28, G01R 1/18

(21) Numéro de dépôt: **87402530.7**

(22) Date de dépôt: **10.11.87**

(54) **Circuit de mesure des caractéristiques dynamiques d'un boîtier pour circuit intégré rapide, et procédé de mesure de ces caractéristiques dynamiques.**

(30) Priorité: **18.11.86 FR 8615996**

(43) Date de publication de la demande:
**08.06.88 Bulletin 88/23**

(45) Mention de la délivrance du brevet:
**15.01.92 Bulletin 92/03**

(84) Etats contractants désignés:
**DE GB IT NL**

(56) Documents cités:
**FR-A- 2 529 385**
**US-A- 4 535 307**

(73) Titulaire: **THOMSON HYBRIDES ET MICROON-DES**
**173, bld Haussmann**
**F-75008 Paris(FR)**

(72) Inventeur: **Gloanec, Maurice**
**THOMSON-CSF SCPI 19, avenue de Messine**
**F-75008 Paris(FR)**
Inventeur: **Jarry, Jacques-Jean**
**THOMSON-CSF SCPI 19, avenue de Messine**
**F-75008 Paris(FR)**
Inventeur: **Lailler, Jean-Luc**
**THOMSON-CSF SCPI 19, avenue de Messine**
**F-75008 Paris(FR)**

(74) Mandataire: **Taboureau, James et al**
**THOMSON-CSF SCPI**
**F-92045 Paris La Défense Cédex 67(FR)**

EP 0 270 422 B1

## Description

La présente invention concerne un dispositif de détermination des performances dynamiques d'un boîtier d'encapsulation de circuit intégré rapide, du genre des circuits intégrés logiques ou linéaires sur arséniure de gallium ou matériaux III-V. L'invention comprend également le procédé de test des caractéristiques dynamiques d'un boîtier, au moyen du dispositif selon l'invention.

Le développement des nouvelles techniques de circuits intégrés sur arséniure de gallium Ga As ou composés ternaires Ga Al As de matériaux de la famille III-V, fonctionnant à des fréquences de travail supérieures à 1 GHz, nécessite la disponibilité de moyens d'encapsulation de très hautes performances en vitesse.

Le problème posé par l'encapsulation de ces circuits intégrés, dits subnanosecondes, consiste à assurer l'assemblage d'un composant dans un boîtier sans que celui-ci ne détériore les performances électriques intrinsèques du circuit intégré encapsulé. Pour ce type de circuit intégré, les boîtiers sont très généralement des boîtiers céramiques plats, et la demande de brevet FR-A-25 29 385, appartenant à la demanderesse, révèle un boîtier plat dont les connexions externes sont constituées entièrement par des micro-bandes adaptées, en impédance : ce boîtier constitue un progrès très intéressant dans l'encapsulation des circuits rapides.

L'objet de la présente invention est un dispositif et un procédé qui permettent la mesure in situ, c'est-à-dire dans les conditions réelles de fonctionnement des circuits intégrés, des performances électriques de boîtiers fonctionnant à très haute fréquence, tels que ceux décrits dans la demande de brevet précédemment citée.

Le dispositif selon l'invention consiste en un ensemble de deux amplificateurs identiques, ou préférentiellement trois amplificateurs identiques intégrés sur une même pastille de matériau semiconducteur, branchés en parallèle, et ayant chacun un plot d'entrée et un plot de sortie indépendants des plots d'entrée et de sortie des autres amplificateurs. Deux amplificateurs sont intégrés en parallèle - plots d'entrées voisins, plots de sorties voisins - et deux amplificateurs sont intégrés tête-bêche.

Le procédé consiste à monter cette pastille d'amplificateur dans le boîtier dont on veut mesurer les caractéristiques à très grande vitesse, et à mesurer les coefficients de transmission du boîtier entre connexions d'accès extérieures, choisies par paires sur différents côtés du boîtier.

De façon plus précise, l'invention concerne un circuit de mesure des caractéristiques dynamiques d'un boîtier d'encapsulation pour circuit intégré rapide (≧1GHz), caractérisé en ce qu'il comporte, supporté par un substrat en matériau semiconducteur au moins deux amplificateurs identiques dont :

- l'impédance d'entrée correspond à l'impédance d'entrée du circuit intégré à encapsuler dans le boîtier,
- l'impédance de sortie est identique à l'impédance de sortie dudit circuit intégré,
- les alimentations sont distinctes et le dessin d'implantation est très espacé pour que le couplage électrique soit nul,
- les métallisations des plots d'entrées et de sorties sont situées sur les bords du substrat pour que les liaisons extérieures soient courtes, lesdits bords étant choisis en regard des bords du boîtier d'encapsulation qui supportent des connexions d'accès extérieur.

L'invention sera mieux comprise par la description plus détaillée qui suit du dispositif et du procédé, cette description s'appuyant sur les figures jointes en annexes, qui représentent :

- figures 1 et 2 : les deux pastilles supportant les amplificateurs montés en parallèle et en anti-parallèle, selon l'invention,
- figure 3 : une pastille supportant trois amplificateurs, dont un monté en anti-parallèle, constituant une alternative selon l'invention aux figures 1 et 2,
- figure 4 : schéma du procédé de mesure selon l'invention du coefficient de transmission d'un boîtier,
- figure 5 : schéma du procédé de mesure selon l'invention du coefficient de couplage entre deux connexions d'accès utilisées en entrées.
- figure 6 : schéma du procédé de mesure selon l'invention du coefficient de couplage entre deux connexions d'accès utilisées en sorties.
- figure 7 : schéma du procédé de mesure selon l'invention du coefficient de couplage entre une connexion d'accès utilisée en entrée et une connexion d'accès utilisée en sortie, situées côte à côte,
- figure 8 : schéma du procédé de mesure selon l'invention du coefficient de couplage entre une connexion d'accès utilisée en sortie et une connexion d'accès utilisée en entrée, séparées par un écran.

Outre les performances mécaniques telles que l'herméticité ou la capacité à évacuer les calories, la qualité d'un boîtier utilisé en hautes fréquences est directement liée à l'aptitude qu'il présente à véhiculer les signaux très rapides de l'environnement extérieur (carte support) à la puce du circuit intégré. Ceci peut se résumer par deux critères électriques de qualité :

- la transmission électrique des connexions d'accès
- le découplage électrique entre les différentes connexions d'accès.

Le premier critère caractérise la faible dégradation des signaux cheminants, le second critère caractérise la faible diaphonie entre connexions d'accès pouvant être la cause de signaux parasites indésirables.

La mesure de ces deux paramètres en vraie grandeur est extrêmement délicate puisqu'elle nécessiterait d'aller prélever au sein même du circuit intégré les grandeurs électriques permettant ainsi de juger de la qualité des liaisons assurées.

Le dispositif selon l'invention permet d'opérer les mesures quantitatives des performances dynamiques d'un boîtier, principalement en termes de couplage dans un environnement réel.

Ce paramètre est une donnée très importante surtout dans le cadre d'encapsulation de circuits intégrés linéaires de traitement du signal qui utilisent des grandeurs analogiques très précises, de faibles amplitudes, en cohabitation avec des signaux d'horloge de niveaux élevés, dont la fréquence peut être supérieure à 1 GHz.

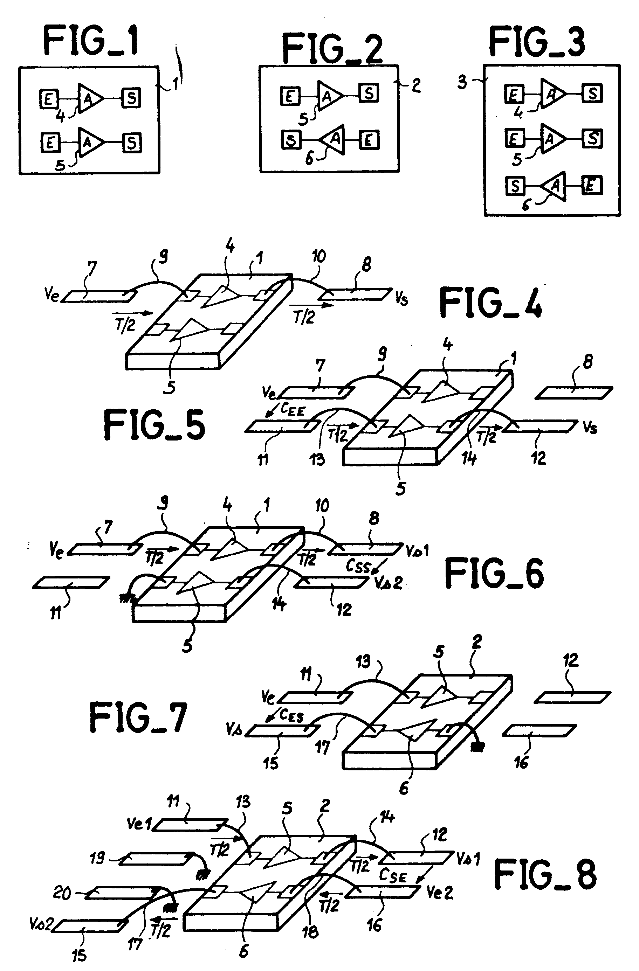

L'analyse complète des spécifications des boîtiers nécessite la disponibilité de deux types de circuits illustrés de façon synoptique sur les figures 1 et 2.

Dans un premier cas, en figure 1, sur une pastille 1 de matériau semiconducteur sont intégrés deux amplificateurs 4 et 5, selon un dessin d'implantation tel qu'ils sont montés en parallèle : les deux plots d'entrées sont côte à côte sur un même bord du substrat 1, les deux plots de sorties sont côte à côte sur un bord opposé du substrat.

Dans un deuxième cas, en figure 2, sur une pastille 2 de matériau semiconducteur sont intégrés deux amplificateurs 5 et 6, mais leur dessin d'implantation est cette fois anti-parallèle ou tête-bêche : le plot d'entrée de l'amplificateur 5 est voisin, sur un même bord du substrat 2, du plot de sortie de l'amplificateur 6, et le plot de sortie de l'amplificateur 5 est voisin, sur un bord opposé du substrat, du plot d'entrée de l'amplificateur 6.

L'utilisation de ces deux types de circuits sera expliquée plus loin : elle correspond à des mesures sur des connexions d'accès situées sur deux bords opposés d'un boîtier. Si des mesures doivent être faites sur des connexions d'accès situées sur deux bords adjacents d'un boîtier à connexions périmétriques, les dessins d'implantation des amplificateurs sont tels que les plots d'entrées et sorties sont sur deux bords adjacents du substrat 1 ou 2, de façon que les liaisons par ruban métallique, entre la position du circuit et les connexions externes soient le plus court possible, pour ne pas introduire d'éléments nouveaux dans la mesure des caractéristiques d'un boîtier.

Si les deux types de circuits illustrés en figures 1 et 2 doivent être utilisés - cela dépend des mesures à faire sur un boîtier - le circuit illustré en figure 3 apporte une solution efficace. Sur un substrat 3 en matériau semiconducteur sont implantés trois amplificateurs 4, 5 et 6 qui, pris deux à deux, correspondent aux circuits précédents :

- les amplificateurs 4 et 5 sont montés en parallèle, comme sur la figure 1,
- les amplificateurs 5 et 6 sont montés en anti-parallèle, comme sur la figure 2.

Bien entendu, dans les trois cas de figures, les amplificateurs sont identiques, et leur conception ainsi que les matériaux choisis - Ga As, Al Ga As......etc - permettent de travailler à des fréquences au moins aussi élevées que celles pour lesquelles on veut mesurer le boîtier.

Par ailleurs, étant donné qu'en hyperfréquences un amplificateur est souvent réduit à un seul transistor, les deux ou trois amplificateurs peuvent avantageusement être implantés sur la pastille d'un circuit intégré hyperfréquence qui est encapsulé dans le boîtier dont on veut mesurer les caractéristiques.

Dans tous les cas, les deux ou les trois amplificateurs des circuits de mesure répondent aux spécifications suivantes :

- fonction de transfert linéaire inverseuse ou non (vs = A ve)
- impédance d'entrée correspondant à l'impédance d'entrée des dispositifs de la famille logique à encapsuler.
- impédance de sortie identique à l'impédance de sortie des circuits de la famille logique à encapsuler

Toutes précautions sont prises au niveau de l'implantation de ces circuits pour que le couplage électrique interne soit nul :

- lignes signal espacées (implantation très lâche)
- alimentations des amplificateurs distinctes

La figure 4 représente le schéma du procédé de mesure du coefficient de transmission d'un boîtier. En vue de simplifier la figure, seuls sont représentés :

- la pastille 1 du circuit de mesure,
- deux connexions d'accès 7 et 8 du boîtier,
- les liaisons 9 et 10 par fils ou rubans, entre l'amplificateur 4 et les connexions 7 et 8.

L'amplificateur 5 n'est pas utilisé pour la mesure du coefficient de transmission.

Soit 7 la connexion d'entrée et 8 la connexion de sortie du boîtier : dans le boitier de la demande de brevet FR-A-25 29 385, ce sont des microbandes adaptées pour la fréquence d'utilisation.

Soit T le coefficient de transmission du boîtier : ce coefficient se partage en T/2 à l'entrée du boîtier et T/2 à la sortie du boîtier. Il est dû aux éléments parasites : capacités, self des rubans 9 et 10, fuites dans les diélectriques...etc.

Si on envoie un signal électrique connu $V_e$ - tel qu'un train d'impulsions - sur la connexion d'entrée 7, on peut mesurer un signal $V_S$ sur la connexion de sortie 8, de la forme

$$V_S = A . V_e . T$$

A étant le gain de l'amplificateur 4.
Le coefficient de transmission T

$$T = (1/A) . (V_S/V_e)$$

est ainsi mesuré à la fréquence d'utilisation du boîtier.

Connaissant T , on peut mesurer le couplage entre deux connexions d'accès voisines, utilisées en entrées. Selon la figure 5, un circuit de mesure conforme à la figure 1, ou à la figure 3, est utilisé : l'entrée du premier amplificateur 4 est connecté par un ruban 9 à la connexion d'entrée 7, et sa sortie n'est par connectée. L'amplificateur 5, parallèle à l'amplificateur 4, a son entrée connectée à une connexion externe 11, voisine de la connexion 7, et sa sortie connectée à une connexion externe 12, sur un bord opposé du boîtier à celui qui supporte les connexions d'entrées 7 et 11.

Un signal d'entrée $V_e$ est appliqué sur la connexion 7 : l'amplificateur 5 délivre un signal de sortie $V_S$, s'il y a couplage $C_{E/E}$ entre les entrées 7 et 11.

$$V_S = C_{E/E} . A . V_e . T$$
$$C_{E/E} = (1/A) . (1/T) . (V_S/V_e)$$

Pour mesurer le coefficient de couplage entre deux connexions de sorties voisines, on utilise le câblage de la figure 6. Un circuit de mesure selon la figure 1 ou la figure 3 a son premier amplificateur 4 connecté par des rubans 9 et 10 à la connexion d'entrée 7 et à la première connexion de sortie 8. Le second amplificateur 5, parallèle au premier amplificateur 4, a son entrée mise à la masse, et sa sortie connectée à une seconde connexion de sortie 12, voisine de la première sortie 8.

Un signal d'entrée $V_e$ est appliqué sur la connexion 7 : l'amplificateur 5 délivre un signal de sortie $V_{S2}$ s'il y a couplage $C_{S/S}$ avec le signal $V_{S1}$ , entre les deux connexions de sorties 8 et 12.

$$V_{S2} = C_{S/S} . V_{S1} = C_{S/S} . A.V_e.T$$
$$C_{S/S} = (1/A) . (1/T) . V_{S2}/V_e$$

Si deux connexions voisines, sur un même bord du boîtier, sont utilisées l'une en entrée, l'autre en sortie, le câblage de la figure 7 est utilisé pour connaitre le coefficient de couplage $C_{E/S}$ entrée/sortie.

Le circuit de mesure utilisé est celui de la figure 2, ou la portion de la figure 3, dans lesquelles deux amplificateurs 5 et 6 sont montés en antiparallèle ou tête-bêche.

L'amplificateur 5 a son entrée connectée à la connexion d'entrée 11, et sa sortie n'est pas connectée. L'amplificateur 6 a son entrée à la masse, et sa sortie connectée à la connexion 15, qui est voisine de la connexion d'entrée 11.

Le couplage dans ce cas s'effectue directement entre les deux microbandes d'entrée-sortie 11 et 15. Puisque les microbandes 12 et 17, situées sur le bord opposé du boîtier, ne sont reliées à rien, le gain A des amplificateurs et le coefficient de transmission T du boîtier n'interviennent pas. Le signal de sortie $V_s$ est directement dérivé du signal d'entrée $V_e$ par le couplage $C_{E/S}$ entre les connexions 11 et 15 :

$$V_s = C_{E/S} . V_e$$
$$C_{E/S} = (V_s/V_e)$$

Enfin, la figure 8 représente le cas de la mesure du coefficient de couplage entre une sortie et une entrée, situées sur un même bord du boîtier mais séparées par un écran constitué par une ou deux connexions 19 et 20 mises à la masse.

Le circuit de mesure utilisé est celui de la figure 2 ou de la figure 3 dans lesquelles deux amplificateurs 5 et 6 sont implantés en anti-parallèle ou tête-bêche. L'amplificateur 5 est connecté à deux connexions 11 et 12, et l'amplificateur 6 à deux connexions 15 et 16 : les connexions 12 et 16, voisines sur un bord du boîtier, sont couplées, et les connexions 11 et 15, sur un autre bord du boîtier, sont séparées par l'écran des connexions 19 et 20. S'il y a couplage entre 11 et 15, c'est par l'intermédiaire de 12 et 16.

Selon le cas de la figure 4, on a :

$$V_{S2} = A . V_{e2} . T$$

mais le signal $V_{e2}$, sur la connexion 16, n'existe que parce qu'il y a couplage $C_{S/E}$ avec le signal $V_{S1}$ sur la connexion 12

$$V_{e2} = C_{S/E} . V_{S1} = C_{S/E} . A . V_{e1} . T$$

donc

$$V_{S2} = A.T.C_{S/E} . A.V_{e1} . T$$
$$C_{S/E} = 1/(A^2 . T^2) . (V_{S2}/V_{e1})$$

Les figures 4 à 8 sont représentées avec un circuit à deux amplificateurs selon les figures 1 et 2 : elles restent valables si au lieu de monter deux circuits dans un boîtier pour en faire les mesures dynamiques, on ne monte qu'un seul circuit selon la figure 3, dont les amplificateurs sont utilisés deux à deux, selon le type de mesure à faire.

Lorsqu'un boîtier est caractérisé en performance dynamique, le ou les circuits de mesure peuvent être désoudés, et le circuit intégré d'utilisation est soudé dans le boîtier.

Le champ d'application de l'invention couvre tous les secteurs de l'électronique rapide où se pose le problème de l'encapsulation de familles de circuits à très hautes performances. Il n'exclut absolument pas les nouvelles générations de circuits intégrés silicium présentant des spécifications en vitesse très intéressantes.

**Revendications**

1. Circuit de mesure des caractéristiques dynamiques d'un boîtier d'encapsulation pour circuit intégré rapide, caractérisé en ce qu'il comporte, supporté par un substrat en matériau semiconducteur (1) au moins deux amplificateurs (4, 5) identiques, dont :

   - l'impédance d'entrée correspond à l'impédance d'entrée du circuit intégré à encapsuler dans le boîtier,
   - l'impédance de sortie est identique à l'impédance de sortie dudit circuit intégré,
   - les alimentations sont distinctes et le dessin d'implantation est très espacé pour que le couplage électrique soit nul,
   - les métallisations des plots d'entrées (E) et de sorties (S) sont situées sur les bords du substrat (1) pour que les liaisons extérieures soient courtes, lesdits bords étant choisis en regard des bords du boîtier d'encapsulation qui supportent des connexions d'accès extérieur (7, 8, 11, 12).

2. Circuit de mesure selon la revendication 1, caractérisé en ce qu'il comprend deux amplificateurs (4,5) montés en parallèle, dont les métallisations des plots d'entrées (E) sont voisines, sur un premier bord du substrat (1), et dont les métallisations des plots de sorties (S) sont voisines, sur un second bord du substrat (1).

3. Circuit de mesure selon la revendication 1, caractérisé en ce qu'il comprend deux amplificateurs (5, 6) montés en anti-parallèle, dont les métallisations des plots d'entrée (E) du premier amplificateur (5) et de sortie (S) du second amplificateur (6) sont voisines, sur un premier bord du substrat (2), et dont les métallisations des plots de sortie (S) du premier amplificateur (5) et d'entrée (E) du second amplificateur (6) sont voisines, sur un second bord du substrat (2).

4. Circuit de mesure selon la revendication 1, caractérisé en ce qu'il comprend trois amplificateurs (4, 5, 6), dont deux (4, 5) sont montés en parallèle et deux (5, 6) sont montés en anti-parallèle.

5. Procédé de mesure des caractéristiques dynamiques d'un boîtier d'encapsulation de circuit intégré rapide, caractérisé en ce que, pour mesurer le coefficient de transmission T entre une connexion d'entrée (7) et une connexion de sortie (8) du boîtier :

   - un circuit de mesure selon la revendication 1 est monté dans le boîtier,
   - l'une des connexions d'entrée (7) du boîtier est branchée par un ruban métallique (9) à la métallisation du plot d'entrée du premier amplificateur (4),
   - l'une des connexions de sortie (8) du boîtier est branchée par un ruban métallique (10) à la métallisation du plot de sortie du même amplificateur (4),
   - un signal $(V_e)$ est adressé sur la connexion d'entrée (7)
   - le signal de sortie $(V_S)$ est égal à :

   $$V_S = A.V_e.T \text{ soit } T = (1/A).(V_s/V_e)$$

   A étant le gain de l'amplificateur (4).

6. Procédé de mesure selon la revendication 5, caractérisé en ce que, pour mesurer le coefficient de couplage $C_{E/E}$ entre deux connexions d'entrées (7, 11), voisines du boîtier:

   - le premier amplificateur (4) du circuit de mesure n'est pas branché en sortie,
   - le second amplificateur (5), parallèle au premier (4), est branché sur l'autre connexion d'entrée (11) et sur l'autre connexion de sortie (12) du boîtier,
   - un signal $(V_e)$ est adressé sur la connexion d'entrée (7) du premier amplificateur (4)
   - le signal de sortie $(V_S)$ sur le second amplificateur (5) est égal à :

   $$V_S = C_{E/E}.A.V_e.T \text{ soit } C_{E/E} = 1/(A.T).-(V_s/V_e).$$

7. Procédé de mesure selon la revendication 5, caractérisé en ce que, pour mesurer le coefficient de couplage $C_{S/S}$ entre deux connexions de sorties (8, 12), voisines, du boîtier :

- le premier amplificateur (4) du circuit de mesure est branché en entrée et en sortie sur deux connexions (7; 8)
- le second amplificateur (5), parallèle au premier (4), n'est pas branché en entrée, et est branché en sortie sur l'autre connexion (12) du boîtier,
- un signal $V_e$ est adressé sur la connexion d'entrée (7) du premier amplificateur (4)
- le signal de sortie ($V_{S2}$) sur le second amplificateur (5) est égal à :

$$V_{S2} = C_{S/S}. A. V_e. T$$

$$soit \ C_{S/S} = 1/(A.T.).(V_{s2}/V_e)$$

8. Procédé de mesure selon la revendication 5, caractérisé en ce que, pour mesurer le coefficient de couplage $C_{E/S}$ entre la connexion d'entrée (11) voisine d'une connexion de sortie (15) du boîtier,

- le premier amplificateur (5) n'est pas branché en sortie,
- le second amplificateur (6), anti-parallèle avec le premier (5), n'est pas branché en entrée,
- un signal ($V_e$) est adressé sur la connexion d'entrée (11) du premier amplificateur (5)
- le signal de sortie ($V_S$) sur le second amplificateur (6) est égal à :

$$V_S = C_{E/S}. V_e$$

$$soit \ C_{E/S} = V_S/(V_e)$$

9. Procédé de mesure selon la revendication 5, caractérisé en ce que, pour mesurer le coefficient de couplage $C_{S/E}$ entre une connexion de sortie (12) voisine d'une connexion d'entrée (16) du boîtier :

- le premier amplificateur (5) est branché en entrée et en sortie sur deux connexions (11; 12) du boîtier,
- le second amplificateur (6) est branché en entrée et en sortie sur deux autres connexions (16; 15) du boîtier,
- la connexion d'entrée (11) du premier amplificateur (5) et la connexion de sortie (15) du second amplificateur (6) étant séparées par un écran (19, 2o)
- un signal ($V_{e1}$ est adressé sur la connexion d'entrée (11) du premier amplificateur (5)
- le signal de sortie ($V_{S2}$) sur le second amplificateur (6) est égal à

$$V_{S2} = C_{S/E}. V_{S1}$$

$$soit \ C_{S/E} = 1/(A^2 T^2). V_{S2}/(V_{e1}).$$

**Claims**

1. A circuit for measuring the dynamic characteristics of an encapsulating enclosure for a high-speed integrated circuit, characterized by at least two identical amplifiers (4 and 5) supported on a substrate of semiconductor material (1) and of which:

- the input impedance corresponds to the input impedance of the integrated circuit to be encapsulated in the enclosure,
- the output impedance is identical to the output impedance of the said integrated circuit,
- the power supplies are distinct and the implantation pattern is widely spaced out in order to ensure that the electrical coupling effect be zero,
- the metallized areas of the input (E) and (S) terminals are positioned at the edges of the substrate (1) in order that the external connections be short, the edges being selected opposite to the edges of the encapsulation enclosure, which edges support the connections for access from the outside (7, 8, 11 and 12).

2. The measuring circuit as claimed in claim 1, characterized in that it comprises two amplifiers (4 and 5) arranged in parallel and whose metallized areas of the input terminal (E) are adjacent to each other, mounted on a first edge of the substrate (1) and of which the metallized areas of the output terminal (S) are adjacent to each other, on a second edge of the substrate (1).

3. The measuring circuit as claimed in claim 1, characterized in that it comprises two amplifiers (5 and 6) arranged in anti-parallel, whose metallized areas of the input terminals (E) of the first amplifier (5) and output terminals (S) of the second amplifier (6) are adjacent to each other, on a first edge of the substrate (2), and whose metallized areas of the output terminals (S) of the first amplifier (5) and input terminal (E) of the second amplifier (6) are adjacent to each other, on a second edge of the substrate (2).

4. The measuring circuit as claimed in claim 1, characterized in that it comprises three amplifiers (4, 5 and 6) of which two (4 and 5) are placed in parallel and two (5 and 6) are arranged in anti-parallel.

5. A method of measuring the dynamic characteristics of an encapsulation enclosure for a high-speed integrated circuit, characterized in that, in order to measure the coefficient of transmission T between an input connection (7) and an output connection (8) of the enclosure

   - a measurement circuit as claimed in claim 1 is arranged in the enclosure,
   - one of the input connections (7) of the enclosure is connected by means of a metal ribbon (9) at the input terminal metallization of the first amplifier (4),
   - one of the output connections (8) of the enclosure is connected by means of a metal ribbon (10) at the output terminal metallization of the said amplifier (4),
   - a signal ($V_e$) is fed to the input connection (7),
   - the output signal ($V_S$) is:

   $$V_S = A \cdot V_e \cdot T \text{ or } T = (1/A) \cdot (V_S/V_e),$$

   wherein A denotes the gain of the amplifier (4).

6. The method of measurement as claimed in claim 5, characterized in that, in order to measure the coefficient of coupling $C_{E/E}$ between two adjacent input connections (7 and 11) of the enclosure:

   - the first amplifier (4) of the measurement circuit is not connected at the output,
   - the second amplifier (5), parallel to the first one (4), is connected to the other input connection (11) and the other output connection (12) of the enclosure,
   - a signal ($V_e$) is fed to the input connection (7) of the first amplifier (4),
   - the output signal ($V_s$) of the second amplifier (5) is:

   $$V_S = C_{E/E} \cdot A \cdot V_e \cdot T \text{ or } C_{E/E} = 1/(A \cdot T) \cdot (V_S/V_e).:$$

7. A method of measurement as claimed in claim 5, characterized in that for measurement of the coupling coefficient $C_{S/S}$ between two adjacent output connections (8 and 12) of the enclosure:

   - the first amplifier (4) of the measurement circuit is connected at the input and output with two connections (7 and 8),
   - the second amplifier (5), parallel to the first one (4), is not connected at the input and is connected at the output with the other connection (12) of the enclosure,
   - a signal $V_e$ is fed to the input connection (7) of the first amplifier (4),
   - the output signal ($V_{S2}$) of the second amplifier (5) is:

   $$V_{S2} = C_{S/S} \cdot A \cdot V_e \cdot T$$

   or $C_{S/S} = 1/(A \cdot T) \cdot (V_{S2}V_e).$

8. The method of measurement as claimed in claim 1, characterized in that, for the measurement of the coefficient of coupling $C_{E/S}$ between the input connection (11) adjacent to one output connection (15) of the enclosure,

   - the first amplifier (5) is not connected at the output,
   - the second amplifier (6), which is connected in anti-parallel with the first one (5) is not connected at the input,
   - a signal ($V_e$) is fed to the input connection (11) of the first amplifier (5),
   - the output signal ($V_S$) from the second amplifier (6) is:

   $$V_S = C_{E/S} \cdot V_e$$

   or $C_{E/S} = V_S/(V_e).$

9. The method of measurement as claimed in claim 5, characterized in that for measurement of the coefficient of coupling $C_{S/E}$ between one adjacent output connection (12) of an input connection (16) of the enclosure:

   - the first amplifier (5) is connected at the input and at the output with two connections (11 and 12) of the enclosure,
   - the second amplifier (6) is connected at the input and at the output with two other connections (16 and 15) of the enclosure,
   - the input connection (11) of the first amplifier (5) and the input connection (15) of the second amplifier (6) being separated by a screen (19 and 20),
   - a signal ($V_{e1}$) is fed to the input connection (11) of the first amplifier (5) and
   - the output signal ($V_{S2}$) of the second amplifier (6) is:

   $$V_{S2} = C_{S/E} \cdot V_{S1}$$

   or $C_{S/E} = 1/(A^2 T^2) \cdot V_{S2}/(V_{e1}).$

**Patentansprüche**

1. Schaltung zum Messen der dynamischen Charakteristiken eines Einkapselungsgehäuses für eine schnelle integrierte Schaltung, dadurch gekennzeichnet, daß sie wenigstens zwei von einem Substrat aus Halbleitermaterial (1) getragene, identische Verstärker (4, 5) aufweist, deren

-   Eingangsimpedanz der Eingangsimpedanz der in das Gehäuse einzukapselnden integrierten Schaltung entspricht,
-   Ausgangsimpedanz mit der Ausgangsimpedanz der integrierten Schaltung identisch ist,
-   Versorgungen verschieden sind und deren Implantierungsmuster einen großen Abstand aufweisen, damit die elektrische Kopplung null ist,
-   Metallisierungen der Eingangsanschlüsse (E) und der Ausgangsanschlüsse (S) an den Kanten des Substrats (1) angeordnet sind, damit die Außenverbindungen kurz sind, wobei die Kanten gegenüber denjenigen Kanten des Einkapselungsgehäuses gewählt werden, die die Verbindungen für den externen Zugriff (7, 8, 11, 12) tragen.

2.  Meßschaltung gemäß Anspruch 1, dadurch gekennzeichnet, daß sie zwei parallel geschaltete Verstärker (4, 5) umfaßt, deren Metallisierungen der Eingangsanschlüsse (E) an einer ersten Kante des Substrats (1) benachbart sind und deren Metallisierungen der Ausgangsanschlüsse (S) an einer zweiten Kante des Substrats (1) benachbart sind.

3.  Meßschaltung gemäß Anspruch 1, dadurch gekennzeichnet, daß sie zwei antiparallel geschaltete Verstärker (5, 6) umfaßt, von denen die Metallisierungen der Eingangsanschlüsse (E) des ersten Verstärkers (5) und der Ausgangsanschlüsse (S) des zweiten Verstärkers (6) an einer ersten Kante des Substrats (2) benachbart sind und von denen die Metallisierungen der Ausgangsanschlüsse (S) des ersten Verstärkers (5) und der Eingangsanschlüsse (E) des zweiten Verstärkers (6) an einer zweiten Kante des Substrats (2) benachbart sind.

4.  Meßschaltung gemäß Anspruch 1, dadurch gekennzeichnet, daß sie drei Verstärker (4, 5, 6) umfaßt, von denen zwei (4, 5) parallel und zwei (5, 6) antiparallel geschaltet sind.

5.  Verfahren zum Messen der dynamischen Charakteristiken eines Einkapselungsgehäuses einer schnellen integrierten Schaltung, dadurch gekennzeichnet, daß zum Messen des Übertragungskoeffizienten T zwischen einer Eingangsverbindung (7) und einer Ausgangsverbindung (8) des Gehäuses

-   eine Meßschaltung gemäß Anspruch 1 im Gehäuse angebracht wird,
-   eine der Eingangsverbindungen (7) des Gehäuses mittels eines metallischen Bandes (9) an die Metallisierung des Eingangsanschlusses des ersten Verstärkers (4) angeschaltet wird,
-   eine der Ausgangsverbindungen (8) des Gehäuses mittels eines metallischen Bandes (10) an die Metallisierung des Ausgangsanschlusses desselben Verstärkers (4) angeschaltet wird,
-   ein Signal ($V_e$) an die Eingangsverbindung (7) geschickt wird,
-   das Ausgangssignal ($V_S$) gleich

    $V_S = A \cdot V_e \cdot T$ ist, mit $T = (1/A) \cdot (V_S/V_e)$,

    ist, wobei A der Verstärkungsfaktor des Verstärkers (4) ist.

6.  Meßverfahren gemäß Anspruch 5, dadurch gekennzeichnet, daß zum Messen des Kopplungskoeffizienten $C_{E/E}$ zwischen zwei benachbarten Eingangsverbindungen (7, 11) des Gehäuses

-   der erste Verstärker (4) der Meßschaltung am Ausgang nicht angeschlossen wird,
-   der zweite Verstärker (5), der zum ersten (4) parallel ist, an die andere Eingangsverbindung (11) und an die andere Ausgangsverbindung (12) des Gehäuses angeschaltet wird,
-   ein Signal ($V_e$) an die Eingangsverbindung (7) des ersten Verstärkers (4) geschickt wird,
-   das Ausgangssignal ($V_S$) am zweiten Verstärker (5) gleich

    $V_S = C_{E/E} \cdot A \cdot V_e \cdot T$ ist, mit $C_{E/E} = 1/(A \cdot T) \cdot (V_s/V_e)$

    ist.

7.  Meßverfahren gemäß Anspruch 5, dadurch gekennzeichnet, daß zum Messen des Kopplungskoeffizienten $C_{S/S}$ zwischen zwei benachbarten Ausgangsverbindungen (8, 12) des Gehäuses

-   der erste Verstärker (4) der Meßschaltung mit dem Eingang und mit dem Ausgang an zwei Verbindungen (7; 8) angeschaltet wird,

- der zweite Verstärker (5), der zum ersten (4) parallel ist, am Eingang nicht angeschlossen wird und mit dem Ausgang an die andere Verbindung (12) des Gehäuses angeschaltet wird,
- ein Signal ($V_e$) an die Eingangsverbindung (7) des ersten Verstärkers (4) geschickt wird,
- das Ausgangssignal ($V_{S2}$) am zweiten Verstärker (5) gleich

$$V_{S2} = C_{S/2} \cdot A \cdot V_e \cdot T$$

ist, mit $C_{S/S} = 1/(A \cdot T) \cdot (V_{n2}/V_e)$.

8.  Meßverfahren gemäß Anspruch 5, dadurch gekennzeichnet, daß zum Messen des Kopplungskoeffizienten $C_{E/S}$ zwischen der Eingangsverbindung (11) und einer benachbarten Ausgangsverbindung (15) des Gehäuses

- der erste Verstärker (5) am Ausgang nicht angeschlossen wird,
- der zweite Verstärker (6), der zum ersten (5) antiparallel ist, am Eingang nicht angeschlossen wird,
- ein Signal ($V_e$) an die Eingangsverbindung (11) des ersten Verstärkers (5) geschickt wird,
- das Ausgangssignal ($V_S$) am zweiten Verstärker (6)

$$VS = C_{E/S} \cdot V_e$$

ist, mit $C_{E/S} = V_S/(V_e)$.

9.  Meßverfahren gemäß Anspruch 5, dadurch gekennzeichnet, daß zum Messen des Kopplungskoeffizienten ($C_{S/E}$) zwischen einer Ausgangsverbindung (12) und einer benachbarten Eingangsverbindung (16) des Gehäuses

- der erste Verstärker (5) mit dem Eingang und mit dem Ausgang an zwei Verbindungen (11; 12) des Gehäuses angeschaltet wird,
- der zweite Verstärker (6) mit dem Eingang und mit dem Ausgang an zwei andere Verbindungen (16; 15) des Gehäuses angeschaltet wird,
- die Eingangsverbindung (11) des ersten Verstärkers (5) und die Ausgangsverbindung (15) des Zweiten Verstärkers (6) durch einen Schirm (19, 20) getrennt sind,
- ein Signal ($V_{e1}$) an die Eingangsverbindung (11) des ersten Verstärkers (5) geschickt wird,

- das Ausgangssignal ($V_{S2}$) am zweiten Verstärker (6) gleich

$$V_{S2} = C_{S/E} \cdot V_{S1}$$

ist, mit $C_{S/E} = 1/(A^2 T^2) \cdot V_{S2}/(V_{e1})$.

# FIG_1

E 4 A S

E 5 A S 1

# FIG_2

E 5 A S

S 6 A E 2

# FIG_3

3

E 4 A S

E 5 A S

S 6 A E

FIG_4

Ve 7 9 4 1 10 8 Vs
T/2 T/2
5

FIG_5

Ve 7 9 4 1 8
$C_{EE}$
11 13 T/2 T/2 14 12 Vs
5

FIG_6

Ve 7 9 4 1 10 8
T/2 T/2 Vs1
$C_{SS}$
Vs2
11 14 12
5

FIG_7

Ve 11 13 5 2 12
$C_{ES}$
Vs 17
15 16
6

FIG_8

Ve1 11 13 5 2 14
T/2 12
19 Vs1
$C_{SE}$
20 T/2 Ve2
Vs2 18 16
15 17 T/2 6